# EUROPEAN PATENT APPLICATION

(11) **EP 4 101 575 A1**
(43) Date of publication of application: **14.12.2022**
(21) Application number: 21750551.0
(22) Date of filing: 04.02.2021
(51) Int. Cl.: B23K 11/26, B23K 11/24, H02M 9/00, H02M 9/04

(54) **JOINING DEVICE AND METHOD FOR MANUFACTURING JOINED MEMBER**

(30) Priority: 06.02.2020 JP 2020018971
(71) Applicant: Origin Company, Limited, Saitama-shi Saitama 338-0823 (JP)
(72) Inventor: KADOYA, Yasuo, Saitama-shi, Saitama 338-0823 (JP); MIZUTANI, Shinya, Saitama-shi, Saitama 338-0823 (JP); ARAI, Koji, Saitama-shi, Saitama 338-0823 (JP)
(74) Representative: Wallin, Nicholas James
(86) International application number: PCT/JP2021/004124
(87) International publication number: WO 2021/157658

(57) **Abstract**

A joining device provided with: a first circuit to which a primary winding of a first transformer and a first capacitor are connected; a second circuit to which a primary winding of a second transformer and a second capacitor are connected; an electrode connected to a secondary winding of the first transformer and a secondary winding of the second transformer; and a charging switch for switching between energization and non-energization to the first and second capacitors from a power supply without using the transformers. The first circuit has a first discharging switch, and the second circuit has a second discharging switch. A method for manufacturing a joined member includes, with the use of the joining device, supplying an object to be joined with the object to be joined sandwiched by the electrodes, and joining the object to be joined by causing a current to flow in the electrodes sandwiching the object to be joined.

## Description

### TECHNICAL FIELD

The present disclosure relates to a joining device and a method for manufacturing a joined object and, in particular, to a joining device capable of increasing electric power energizing an electrode and a method for manufacturing a joined object using this device.

### BACKGROUND ART

A capacitor-type welder stores welding power in a welding capacitor for a longer time than a discharge time, and discharges the welding power all at once in a short time. Thus, compared to a general AC welder, there are advantages that a degree of overheating of an object to be welded is less, that a weld mark (burn) at a welded site is hardly present, and that distortion is insignificant. An example of such a capacitor-type welder includes: a charging circuit; a welding transformer; a capacitor to which input power is supplied via the charging circuit; a discharge switching element that is connected in parallel with primary winding of the welding transformer and the capacitor, which are connected in series; and a welding electrode that is connected in parallel with secondary winding of the welding transformer (for example, see Japanese Patent Application Publication No. 2013-141700).

### SUMMARY OF THE INVENTION

### PROBLEM TO BE SOLVED BY THE INVENTION

However, in the device disclosed in Japanese Patent Application Publication No. 2013-141700, in the case where the input power is increased so as to increase a current that flows through the welding electrode, a welding current is not increased proportionally to the increased input power. Thus, it is necessary to input the higher electric power in order to obtain the required welding current.

The present disclosure relates to, in view of the above-described problem, a provision of a joining device and a method for manufacturing a joined object that are capable of increasing electric power energizing an electrode in response to an increase in input power.

### MEANS FOR SOLVING THE PROBLEM

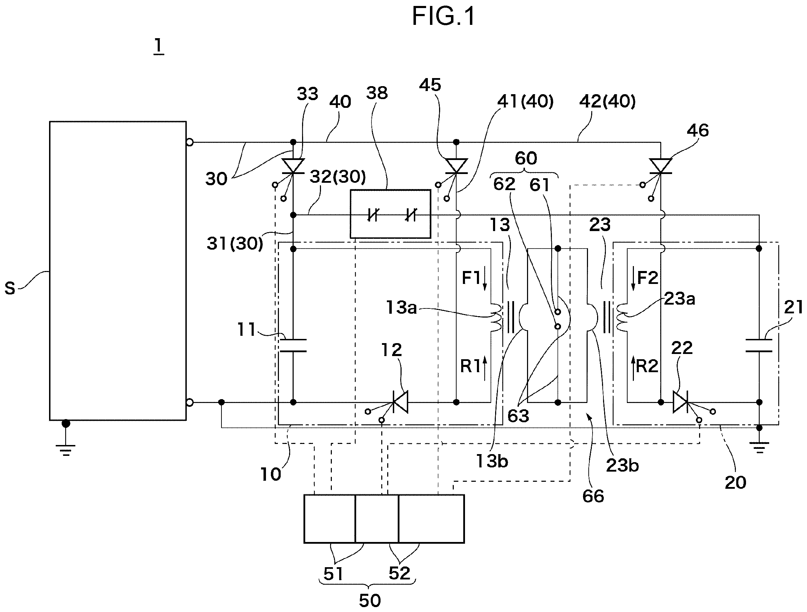

To achieve the above object, a joining device according to a first aspect of the present disclosure includes, as shown in FIG. 1, for example, a first circuit 10 in which a primary-side winding 13a of a first transformer 13 and a first capacitor 11 are connected; a second circuit 20 in which a primary-side winding 23a of a second transformer 23 and a second capacitor 21 are connected; an electrode 60 connected to a secondary-side winding 13b of the first transformer 13 and a secondary-side winding 23b of the second transformer 23, the electrode 60 being configured to sandwich an object to be joined; and a charge switch 33 configured to switch between presence and absence of supply of electric power from a power supply S to the first capacitor 11 and the second capacitor 21 without the primary-side winding 13a of the first transformer 13 and the primary-side winding 23a of the second transformer 23 being interposed, the power supply S supplying electric power to the first circuit 10 and the second circuit 20, wherein the first circuit 10 has a first discharge switch 12 configured to switch between an energized state and a de-energized state, the energized state being a state in which a current caused by energy stored in the first capacitor 11 flows through the first capacitor 11 and the primary-side winding 13a of the first transformer 13 in the first circuit 10, the de-energized state being a state in which the current caused by the energy stored in the first capacitor 11 does not flow through the first capacitor 11 and the primary-side winding 13a of the first transformer 13, and wherein the second circuit 20 has a second discharge switch 22 configured to switch between an energized state and a de-energized state, the energized state being a state in which a current caused by energy stored in the second capacitor 21 flows through the second capacitor 21 and the primary-side winding 23a of the second transformer 23 in the second circuit 20, the de-energized state being a state in which the current caused by the energy stored in the second capacitor 21 does not flow through the second capacitor 21 and the primary-side winding 23a of the second transformer 23.

With such a configuration, the current can be supplied to the electrode from a plurality of systems including the first circuit and the second circuit. Thus, compared to a case where the current is supplied from a single system to the electrode, a large amount of the current can flow through the electrode even when overall current supply capability is the same.

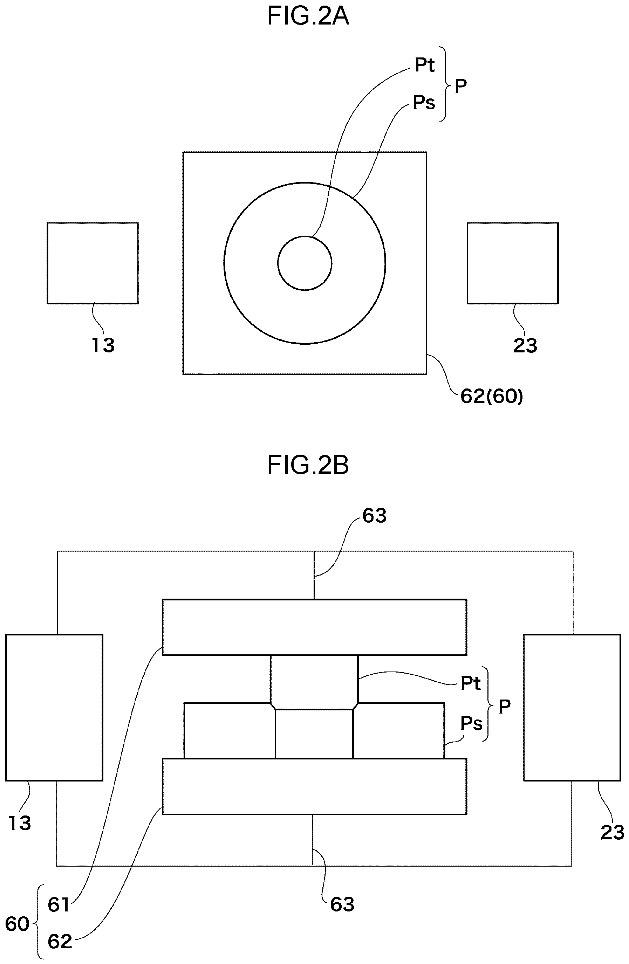

As for a joining device according to a second aspect of the present disclosure, as shown in FIG. 2A, for example, in the joining device according to the first aspect, a plurality of transformers including the first transformer 13 and the second transformer 23 is arranged symmetrically about the electrode 60 in a plan view.

With such a configuration, it is possible to offset an influence of an electromagnetic force from each of the transformers on the object to be joined, which is sandwiched by the electrode.

As for a joining device according to a third aspect of the present disclosure, as shown in FIG. 1, for example, in the joining device according to the first or second aspect, the device further includes a charging wire 30 configured to cause the current to flow from the single power supply S toward the first capacitor 11 and the second capacitor 12 without the primary-side winding 13a of the first transformer 13 and the primary-side winding 23a of the second transformer 23 being interposed, the charging wire 30 being provided with the charge switch 33, the charging wire 30 comprising a connection charging wire 31, 32 with which a connecting portion between the primary-side winding 13a of the first transformer 13 and the first capacitor 11 and a connecting portion between the primary-side winding 23a of the second transformer 23 and the second capacitor 21 are connected.

With such a configuration, a plurality of systems of the capacitors can be charged by using the single power supply. Thus, it is possible to simplify and downsize a device configuration.

As for a joining device according to a fourth aspect of the present disclosure, as shown in FIG. 1, for example, in the joining device according to the third aspect, the device further includes a separation switch 38 provided at the connection charging wire 31, 32, wherein the separation switch 38 switches between energization and de-energization.

With such a configuration, de-energization of the separation switch during discharge makes it possible to discharge the current from the first circuit and the second circuit substantially equally toward the electrode, and to prevent a larger amount of the current than expected from flowing through the first circuit and the second circuit.

As for a joining device according to a fifth aspect of the present disclosure, as shown in FIG. 1, for example, in the joining device according to the fourth aspect, the device further includes a first control circuit 51 configured to control the charge switch 33, the separation switch 38, the first discharge switch 12 , and the second discharge switch 22 in a manner to bring the charge switch 33 and the separation switch 38 into an energized state and bring the first discharge switch 12 and the second discharge switch 22 into a de-energized state to charge the first capacitor 11 and the second capacitor 21, and thereafter bring the charge switch 33 and the separation switch 38 into a de-energized state and bring the first discharge switch 12 and the second discharge switch 22 into an energized state to cause the current to flow through the first circuit 10 and the second circuit 20, to thereby cause the current to flow through the electrode 60, which sandwiches the object P (see FIGs 2A and 2B, for example) to be joined, and join the object P to be joined.

With such a configuration, the object to be joined can be appropriately joined by the relatively small-sized joining device.

As for a joining device according to a sixth aspect of the present disclosure, as shown in FIG. 1, for example, in the joining device according to any one of the first to fifth aspects, the device further includes a first reset wire 41 through which the current flows from the power supply S toward the first circuit 10, through the first reset wire 41, the current from the power supply S bypassing the charge switch 33 and flowing to a connecting portion between the primary-side winding 13a of the first transformer 13 and the first discharge switch 12; a second reset wire 42 through which the current flows from the power supply S toward the second circuit 20, through the second reset wire 42, the current from the power supply S bypassing the charge switch 33 and flowing to a connecting portion between the primary-side winding 23a of the second transformer 23 and the second discharge switch 22; and a second control circuit 52 configured to execute a reset mode for controlling the charge switch 33, the first discharge switch 12, and the second discharge switch 22, before the current flows through the first circuit 10 and the second circuit 20 via the charge switch 33, in a manner to bring the charge switch 33, the first discharge switch 12, and the second discharge switch 22 into the de-energized state to charge at least one of the first capacitor 11 or the second capacitor 21 with the current flowing through at least one of the first reset wire 41 or the second reset wire 42.

With such a configuration, the current in an opposite direction from a direction during discharge can temporarily flows through at least one of the first transformer or the second transformer in the first circuit and the second circuit during charging. Thus, it is possible to release energy stored in the transformer(s) through which the current in the opposite direction from that during discharge has flowed.

As for a joining device according to a seventh aspect of the present disclosure, as shown in FIG. 1, for example, in the joining device according to the sixth aspect, the first reset wire 41 has a first reset switch 45 for switching between energization and de-energization between the power supply S and the first circuit 10, the second reset wire 42 has a second reset switch 46 for switching between energization and de-energization between the power supply S and the second circuit 20, and in a case of executing the reset mode, the second control circuit 52 controls the first reset switch 45 and the second reset switch 46 in a manner to bring the first reset switch 45 and the second reset switch 46 into the energized state simultaneously or with a time difference to charge the first capacitor 11 and the second capacitor 21 simultaneously or with a time difference.

With such a configuration, in the reset mode, the energy that is stored in the first transformer and the second transformer can be released separately.

As for a method for manufacturing a joined object according to an eighth aspect of the present disclosure, as shown in FIGs. 1 and 2B, for example, the method is a method for manufacturing a joined object in which the object P to be joined is joined by using the joining device 1 according to any one of the first to seventh aspects, and the method includes an object supply step of supplying the object P to be joined in a manner to be sandwiched by the electrode 60; and a joining step of causing a current to flow through the electrode 60, which sandwiches the object P to be joined, to join the object P to be joined.

With such a configuration, it is possible to manufacture the joined object while suppressing an increase in size of the joining device.

As for a the joining device according to a ninth aspect of the present disclosure may include, as shown in FIGs 1, 2A, and 2B, for example, a charge/discharge circuit group having a plurality of charge/discharge circuits 10, 20 in which the primary-side windings 13a, 23a of the transformers, the capacitors 11, 21, and discharge switches 12, 22 for switching between energization and de-energization of the capacitors 11, 21 and the primary-side windings 13a, 23a of the transformers are respectively connected; and the electrode 60 that is connected to each of the secondary-side windings 13b, 23b of the transformers 13, 23 of the plural charge/discharge circuits 10, 20 in the charge/discharge circuit group, the electrode 60 being configured to sandwich the object P to be joined, wherein in the plan view, each of the transformers 13, 23 of the plural charge/discharge circuits 10, 20 in the charge/discharge circuit group may be arranged symmetrically about the electrode 60. Here, two, three, or more of the charge/discharge circuits may be provided to the charge/discharge circuit group.

### ADVANTAGE OF THE INVENTION

With the present disclosure, the current can be supplied to the electrode from a plurality of systems including the first circuit and the second circuit. Thus, compared to a case where the current is supplied from a single system to the electrode, a large amount of the current can flow through the electrode even when overall current supply capability is the same.

### BRIEF DESCRIPTION OF DRAWINGS

FIG. 1 is a block diagram of a joining device according to one embodiment.
FIG. 2A is a plan view illustrating a schematic configuration of an electrode and surroundings thereof in the joining device according to the embodiment, and FIG. 2B is a side view thereof.
FIG. 3 is a flowchart of operation of the joining device according to the embodiment.
FIG. 4 is a table illustrating a state of each switch in an operation process of the joining device according to the embodiment.

### DESCRIPTION OF EMBODIMENTS

This application is based on the Patent Application No. 2020-018971 filed on February 6, 2020 in Japan, the contents of which are hereby incorporated in its entirety by reference into the present application, as part thereof.

The present invention will become more fully understood from the detailed description given hereinbelow. Further range of application of the present invention will become clearer from the detailed description given hereinbelow. However, the detailed description and the specific embodiment are illustrated of desired embodiments of the present invention and are described only for the purpose of explanation. Various changes and modifications will be apparent to those ordinary skilled in the art on the basis of the detailed description.

The applicant has no intention to give to public any disclosed embodiment. Among the disclosed changes and modifications, those which may not literally fall within the scope of the patent claims constitute, therefore, a part of the present invention in the sense of doctrine of equivalents.

Description will hereinafter be made of each embodiment with reference to the drawings. The same or corresponding members are denoted with the same reference numerals in all the drawings, and their descriptions are not repeated.

First, referring to FIG. 1, a description will be made on a joining device 1 according to an embodiment. FIG. 1 is a block diagram of the joining device 1. The joining device 1 is a device for joining a joining object P (an object P to be joined) (see FIGs. 2A and 2B), which is typically constructed of two metal objects, by causing a current to flow through the joining object P while pressurizing the joining object P. The joining device 1 includes: an electrode 60 that sandwiches the joining object P; and a circuit that supplies electric power from a power supply S to the electrode 60. The circuit includes a first circuit 10, a second circuit 20, charging wire 30, a charge switch 33, a separation switch 38, reset wire 40, and a control circuit 50. The power supply S is typically constructed of a rectifier/smoothing circuit, which receives and converts commercial AC power into DC power, a combination of an AC generator and the rectifier/smoothing circuit, a DC generator, or the like. Although not included in components of the joining device 1 in this embodiment, components (for example, a portion corresponding to the rectifier/smoothing circuit) of the power supply S may partially or entirely be included in the components of the joining device 1.

The first circuit 10 has a first capacitor 11, a first discharge switch 12, and first primary winding 13a that is primary-side winding of a first transformer 13, and these components are connected by being provided in series in wire that connects itself in the shape of ring. The first capacitor 11 stores electric charges so as to be able to supply, to the electrode 60, a relatively large amount of a current that is required to join the joining object P (see FIGs. 2A and 2B). Capacity of the first capacitor 11 is preferably determined from joining capability requested for the joining object P. The first discharge switch 12 is OFF when the electric charges are stored in the first capacitor 11, and is ON when the first capacitor 11 is discharged (when the electric charges stored in the first capacitor 11 are supplied to the electrode 60). A thyristor is typically used as the first discharge switch 12, and it is configured that ON-OFF of the first discharge switch 12 can be controlled by adjusting presence or absence of input of a gate signal. The first primary winding 13a constitutes a part of the first transformer 13. Thus, the joining device 1 includes the first transformer 13. The first transformer 13 includes the first primary winding 13a and first secondary winding 13b, and is configured to increase an amount of the current flowing through the first secondary winding 13b to be larger than an amount of the current flowing through the first primary winding 13a.

The second circuit 20 is configured in the same manner as the first circuit 10. The second circuit 20 has a second capacitor 21, a second discharge switch 22, and second primary winding 23a that is primary-side winding of a second transformer 23, and these respectively correspond to the first capacitor 11, the first discharge switch 12, and the first primary winding 13a in the first circuit 10. Thus, the joining device 1 also includes the second transformer 23. The second transformer 23 includes the second primary winding 23a and second secondary winding 23b, and corresponds to the first transformer 13 in the first circuit 10.

The charging wire 30 is wire that connects the power supply S to the first circuit 10 and the second circuit 20. One end of the charging wire 30 is connected to one terminal of the power supply S, and the other end thereof is branched into first charging wire 31 and second charging wire 32. Of the branched charging wire 30, the first charging wire 31 is connected to wire (a connecting portion) that connects the first primary winding 13a and the first capacitor 11 in the first circuit 10, and the second charging wire 32 is connected to wire (a connecting portion) that connects the second primary winding 23a and the second capacitor 21 in the second circuit 20. In other words, the first charging wire 31 is connected to wire on which the first discharge switch 12 does not exist among the wire that connects the first primary winding 13a and the first capacitor 11 in the first circuit 10, and the second charging wire 32 is connected to wire on which the second discharge switch 22 does not exist among the wire that connects the second primary winding 23a and the second capacitor 21 in the second circuit 20. The first charging wire 31 and the second charging wire 32 cooperatively serve as wire that connects the first circuit 10 (and thus the first capacitor 11) and the second circuit 20 (and thus the second capacitor 21), and correspond to connection charging wire. The charging wire 30 is provided with the charge switch 33. The charge switch 33 is ON when the current is supplied to the first circuit 10 in order to store the electric charges in the first capacitor 11 without the first primary winding 13a being interposed therebetween and when the current is supplied to the second circuit 20 in order to store the electric charges in the second capacitor 21 without the second primary winding 23a being interposed therebetween. The charge switch 33 is OFF when the supply of this current is stopped. A thyristor is typically used as the charge switch 33, and it is configured that ON-OFF of the charge switch 33 can be controlled by adjusting the presence or absence of the input of the gate signal. In this embodiment, the charge switch 33 is disposed on a portion of the charging wire 30 prior to being branched into the first charging wire 31 and the second charging wire 32 (on the power supply S side of a branch point). However, instead of this, the charge switch 33 may be disposed on each of the first charging wire 31 and the second charging wire 32. In addition, in this embodiment, the second charging wire 32 is provided with the separation switch 38. The separation switch 38 switches between energization and de-energization of the second charging wire 32 with the current.

The reset wire 40 is provided to cause the current to flow through the transformer in an opposite direction from a direction of the current during discharge of the capacitor in order to eliminate an influence of a phenomenon of biased magnetization that occurs when the current flows through the transformer only in one direction. One end of the reset wire 40 is connected to the power supply S, and the other end thereof is branched into first reset wire 41 and second reset wire 42. Of the branched reset wire 40, the first reset wire 41 is connected to wire on which the first capacitor 11 does not exist among the wire that connects the first discharge switch 12 and the first primary winding 13a in the first circuit 10, and the second reset wire 42 is connected to wire on which the second capacitor 21 does not exist among the wire that connects the second discharge switch 22 and the second primary winding 23a in the second circuit 20. The first reset wire 41 is provided with a first reset switch 45. The first reset switch 45 is ON when supplying a reset current to the first circuit 10, and is OFF when the supply of the reset current is stopped. Here, the reset current is a current that flows through the primary winding of the transformer in the opposite direction from the direction of the current during the discharge of the capacitor. When the first reset switch 45 is ON in an OFF state of the first discharge switch 12, a closed circuit that connects the power supply S, the first primary winding 13a, and the first capacitor 11 is formed. The second reset wire 42 is provided with a second reset switch 46. The second reset switch 46 is ON when supplying the reset current to the second circuit 20, and is OFF when the supply of the reset current is stopped. When the second reset switch 46 is ON in an OFF state of the second discharge switch 22, a closed circuit that connects the power supply S, the second primary winding 23a, and the second capacitor 21 is formed. A thyristor is typically used as each of the first reset switch 45 and the second reset switch 46, and it is configured that ON-OFF of each of the first reset switch 45 and the second reset switch 46 can be controlled by adjusting the presence or the absence of the input of the gate signal.

The control circuit 50 controls operation of the joining device 1 by controlling ON-OFF of each of the switches. In this embodiment, the control circuit 50 includes a first control circuit 51 and a second control circuit 52. The first control circuit 51 is configured to provide a gate control signal to each of the first discharge switch 12, the second discharge switch 22, and the charge switch 33 so as to be able to control ON-OFF thereof. In addition, the first control circuit 51 is configured to provide a control signal to the separation switch 38 so as to be able to control ON-OFF thereof. The second control circuit 52 is configured to provide the gate control signal to each of the first reset switch 45, the second reset switch 46, the first discharge switch 12, and the second discharge switch 22 so as to be able to control ON-OFF thereof. In the illustrated example, the first control circuit 51 and the second control circuit 52 provided in the control circuit 50 are illustrated as separate components from a functional perspective. However, the first control circuit 51 and the second control circuit 52 are typically constructed harmoniously. That is, typically, the control circuit 50 as a whole is configured to appropriately control each of the above-described switches and exert both of the function of the first control circuit 51 and the function of the second control circuit 52.

The electrode 60 is provided in an electrode circuit 66. In addition to the electrode 60, the electrode circuit 66 has: the first secondary winding 13b that is secondary-side winding of the first transformer 13; and the second secondary winding 23b that is secondary-side winding of the second transformer 23, and the first secondary winding 13b and the second secondary winding 23b are each provided in wire that connects itself in the shape of ring. This ring-like shape wire is provided with electrode wire 63 that connects a pair of wire connecting the first secondary winding 13b and the second secondary winding 23b, and the electrode 60 is disposed in this electrode wire 63. With such a configuration, the electrode 60 is configured to be able to receive the supply of the electric power from both of the first circuit 10 and the second circuit 20. The electrode 60 has an upper electrode 61 and a lower electrode 62 and is configured that the entire electrode wire 63 can be conducted when the joining object P is held between the upper electrode 61 and the lower electrode 62.

FIG. 2A and FIG. 2B are schematic configuration views of the electrode 60 and surroundings thereof. FIG. 2A is a plan view, and FIG. 2B is a side view. For convenience of the description, the upper electrode 61 is not illustrated in FIG. 2A. As illustrated in FIG. 2A, in this embodiment, the lower electrode 62 is formed in a rectangular shape in the plan view, and the first transformer 13 and the second transformer 23 are respectively arranged on left and right sides of the lower electrode 62 in a manner to place the lower electrode 62 therebetween. In the plan view, the first transformer 13 and the second transformer 23 are arranged symmetrically about the lower electrode 62, are typically arranged to be point-symmetric about the center of gravity of the lower electrode 62 as a center of symmetry, or are arranged to be line-symmetric about an imaginary linear line, which passes a center of the lower electrode 62, as an axis of symmetry. Just as described, due to the symmetrical arrangement of the first transformer 13 and the second transformer 23 about the electrode 60, in the case where the same amount of the current flows through each of the first transformer 13 and the second transformer 23, electromagnetic forces that are generated from the first transformer 13 and the second transformer 23 are equally applied to the joining object P, which is sandwiched by the electrode 60. As a result, it is possible to suppress unintended movement of the joining object P. In view of this objective, "arranged symmetrically" does not have to be strictly geometric symmetry. The first transformer 13 and the second transformer 23 only need to be arranged to place the electrode 60 therebetween in a symmetric manner to such extent that the unintended movement of the joining object P can be suppressed by the electromagnetic forces generated from the first transformer 13 and the second transformer 23.

As it can be comprehended from FIG. 2A and FIG. 2B, in this embodiment, the joining object P, which is sandwiched by the electrode 60, includes: a fitting object Pt that is formed in a columnar shape; and an annular object Ps that is formed in a ring shape. At a center of a thick disc shape of the annular object Ps, a columnar hollow portion (internal space), a diameter of which is one size smaller than an outer diameter of the fitting object Pt, is formed. The fitting object Pt and the annular object Ps are typically formed of metal, such as carbon steel, alloy steel, cast iron, or the like. The fitting object Pt and the annular object Ps may be formed of the same type of material or may be formed of different materials. In the joining object P, the fitting object Pt and the annular object Ps are joined by a Ring Mash (registered trademark) joining method (hereinafter simply referred to as "Ring Mash joining"). Ring Mash joining is a method for joining in solid-phase an outer surface of the fitting object Pt completely or almost uniformly to an inner surface of the annular object Ps for an entire circumference by fitting the fitting object Pt, a fitting diameter of which is one size larger than a space diameter, into the internal space of the annular object Ps by applying a welding current while pressurizing the fitting object Pt. In this solid-phase joining, the objects to be joined are brought into close contact with each other and are then heated to a lower temperature than a melting point, and the objects to be joined are thereby joined without being melted. When the joining object P is subjected to Ring Mash joining, the welding current may perform hardening (quenching) in a joined portion. In the case where hardening has been performed, it is preferable to cause the welding current to flow through the joining object P again to temper. A description will hereinafter be made on an operation of the joining device 1 by using, as an example, a case where the joining object P is joined by being energized twice.

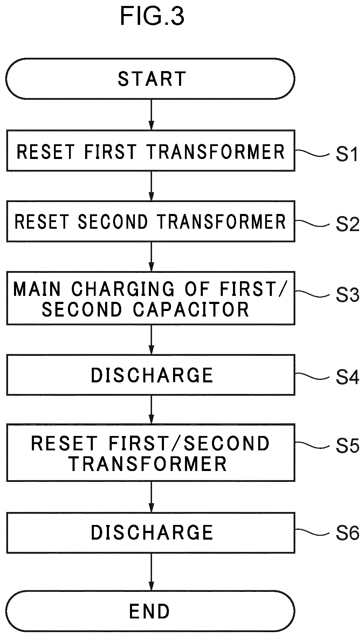

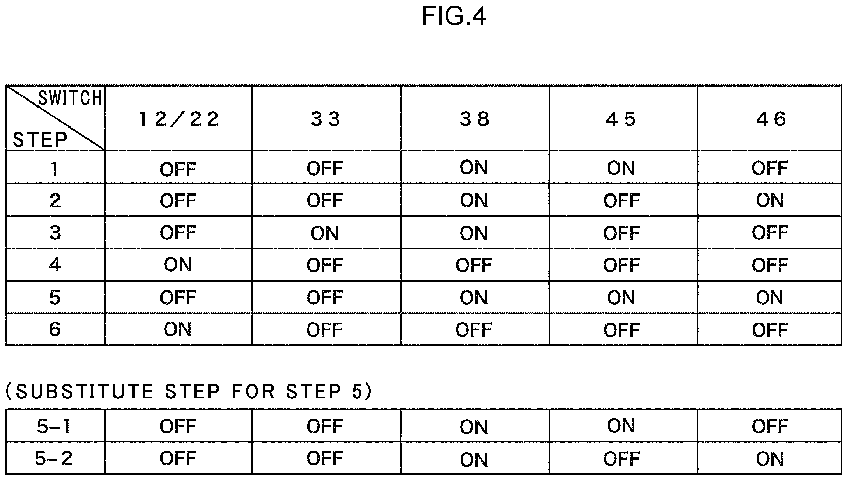

FIG. 3 is a flowchart for explaining the operation of the joining device 1. FIG. 4 is a table illustrating a state of each of the switches in an operation process of the joining device 1. In the following description on an operation of the joining device 1, FIGs. 1, 2A, and 2B will appropriately be referred in regard to the configuration of the referred joining device 1. The operation of the joining device 1 described below makes it possible to manufacture a joined object in which the fitting object Pt and the annular object Ps are joined. Accordingly, the following description on the operation of the joining device 1 also serves as a description on a method for manufacturing the joined object. When the joining device 1 is stopped, each of the switches other than the separation switch 38 is OFF (a de-energized state). During a normal time, the separation switch 38 is ON (an energizable state). When the joining device 1 is activated, the control circuit 50 turns ON the first reset switch 45 to reset the first transformer 13 (S1). This step is executed to eliminate the biased magnetization in the case where the biased magnetization occurs to the transformer due to the last actuation of the joining device 1. When the first reset switch 45 is turned ON, the current from the power supply S flows into the first circuit 10 via the charging wire 30, the reset wire 40 and the first reset wire 41 (that is, by bypassing the charge switch 33), and flows through the first primary winding 13a in a direction denoted by a reference sign R1 in FIG. 1. Due to the current that flows through the first primary winding 13a in the R1 direction, the biased magnetization of the first transformer 13 is eliminated. Then, the current that has flowed through the first primary winding 13a reaches the first capacitor 11, flows into the second circuit 20 via the first charging wire 31 and the second charging wire 32, and reaches the second capacitor 21. In this way, the first capacitor 11 and the second capacitor 21 are charged. In this step (S1), in order to reliably reset the first transformer 13, the second reset switch 46 is not turned ON. This step (S1) continues until the first transformer 13 is brought into a reset allowable state. Here, the reset allowable state of the transformer typically means a state where, even in the case where a series of welding steps is continuously executed to charge the capacitor and discharge the charged capacitor to cause the flow of the welding current, the biased magnetization of the transformer does not progress, and the transformer can be operated stably. It is possible to determine whether the transformer is brought into the reset allowable state, for example, by using a detector (not illustrated) to detect that a voltage of the capacitor charged by the current flowing through the primary winding of the transformer has become equal to or higher than a reset determination voltage set value or to detect that the current flowing through the primary winding has become equal to or higher than a reset determination current set value.

When the first transformer 13 is brought into the reset allowable state, the control circuit 50 turns OFF the first reset switch 45 and turns ON the second reset switch 46 to reset the second transformer 23 (S2). This step is also executed to eliminate the biased magnetization. When the first reset switch 45 is turned OFF and the second reset switch 46 is turned ON, the current from the power supply S flows into the second circuit 20 via the charging wire 30, the reset wire 40 and the second reset wire 42 (that is, by bypassing the charge switch 33), and flows through the second primary winding 23a in a direction denoted by a reference sign R2 in FIG. 1. Due to the current that flows through the second primary winding 23a in the R2 direction, the biased magnetization of the second transformer 23 is eliminated. Then, the current that has flowed through the second primary winding 23a reaches the second capacitor 21, flows into the first circuit 10 via the second charging wire 32 and the first charging wire 31, and reaches the first capacitor 11. In this way, the second capacitor 21 and the first capacitor 11 are continuously charged. In this step (S2), in order to reliably reset the second transformer 23, the first reset switch 45 is OFF. This step (S2) continues until the second transformer 23 is brought into the reset allowable state. The above-described execution of step (S1) of resetting the first transformer 13 and step (S2) of resetting the second transformer 23 corresponds to execution of a reset mode.

When the second transformer 23 is brought into the reset allowable state, the control circuit 50 turns OFF the second reset switch 46 and turns ON the charge switch 33 for main charging of the first capacitor 11 and the second capacitor 21 (S3). Here, main charging of the capacitor means that the current from the power supply S is exclusively used to charge the capacitor without the transformer being interposed. When the second reset switch 46 is turned OFF and the charge switch 33 is turned ON, the current from the power supply S flows through the charging wire 30, flows into the first circuit 10 via the first charging wire 31, and reaches the first capacitor 11 while also flowing into the second circuit 20 via the second charging wire 32 and reaching the second capacitor 21. In this step (S3), the current from the power supply S directly flows into the first capacitor 11 and the second capacitor 21 without the primary windings 13a, 23a of the transformers 13, 23 being interposed. Thus, the first capacitor 11 and the second capacitor 21 are charged faster than charging thereof in steps (S1, S2) of resetting the transformers 13, 23. This step (S3) of main charging is executed until a charging voltage of each of the first capacitor 11 and the second capacitor 21 reaches a target joining voltage, which is set in advance. Then, by the time when this step (S3) is completed, the fitting object Pt and the annular object Ps are supplied between the upper electrode 61 and the lower electrode 62 (an object supply step). That is, this object supply step may be executed at any timing before the activation of the joining device 1, during the reset of the first transformer 13 (S13), during the reset of the second transformer 23 (S2), and during main charging of the first capacitor 11 and the second capacitor 21 (S3). In this embodiment, due to this object supply step, in next discharging step (S4), the fitting object Pt will be brought into contact with the upper electrode 61, the annular object Ps will be brought into contact with the lower electrode 62, and the fitting object Pt and the annular object Ps will be brought into contact with each other.

When the voltage of each of the first capacitor 11 and the second capacitor 21 reaches the target joining voltage, the control circuit 50 turns OFF the charge switch 33 and turns ON the first discharge switch 12 and the second discharge switch 22 to discharge the first capacitor 11 and the second capacitor 21 (S4). At this time, the control circuit 50 turns OFF the separation switch 38 to shut off the energization of the second charging wire 32. When the first capacitor 11 and the second capacitor 21 are discharged, the current from the first capacitor 11 (the current generated due to energy stored in the first capacitor 11) flows through the first primary winding 13a in a reference sign F1 direction via the first discharge switch 12, and the current from the second capacitor 21 (the current generated due to energy stored in the second capacitor 21) flows through the second primary winding 23a in a reference sign F2 direction via the second discharge switch 22. Due to the discharge currents that flow through the first primary winding 13a and the second primary winding 23a, the current flows through the joining object P, which is held between the upper electrode 61 and the lower electrode 62, via the first secondary winding 13b and the second secondary winding 23b, and consequently, the fitting object Pt and the annular object Ps are subjected to solid-phase joining (a joining step). At this time, the currents discharged from the plural capacitors, which are the current discharged from the first capacitor 11 and the current discharged from the second capacitor 21, flow through the joining object P. Accordingly, compared to a case where substantially the same amount of the current as the total current that is discharged from these plural capacitors is discharged from the single capacitor, it is possible to cause the current that is approximately 1.3 to 1.5 times (typically, approximately 1.4 times) higher than the current from the single capacitor to flow through the joining object P. In addition, since the separation switch 38 is OFF, the amount of the discharge current from the first circuit 10 to the electrode 60 can substantially be equal to the amount of the discharge current from the second circuit 20 into the electrode 60, and the electromagnetic forces, which are generated from the first transformer 13 and the second transformer 23 respectively, can equally be applied to the joining object P, which is sandwiched by the electrode 60. Furthermore, since the separation switch 38 is OFF, it is possible to prevent the larger amount of the current than expected from flowing through the first circuit 10 or the second circuit 20. In this discharging step (S4), in the case where the welding current performs hardening in the joined portion during joining of the joining object P, the following steps continue in order to cause the current to flow again through the joining object P for tempering the joining object P.

When the first discharge (S4) is completed, the control circuit 50 turns OFF the first discharge switch 12 and the second discharge switch 22 and turns ON the separation switch 38, the first reset switch 45, and the second reset switch 46 to reset the first transformer 13 and the second transformer 23 (S5). Execution of this step (S5) of resetting the first transformer 13 and the second transformer 23 also corresponds to the execution of the reset mode. A procedure for resetting the first transformer 13 and the second transformer 23 is the same as that in resetting steps (S1, S2) as described above. A reason why, in step (S5) herein, the first reset switch 45 and the second reset switch 46 are simultaneously turned ON to reset the first transformer 13 and the second transformer 23 simultaneously is because it takes shorter time to reset the first transformer 13 and the second transformer 23 than the time in the previous steps (S1, S2) due to a fact that the fitting object Pt and the annular object Ps have been joined by the previous discharge (S4) and have been brought into short-circuit states. In addition, due to such a circumstance, charging the first capacitor 11 and the second capacitor 21 in association with the reset of the first transformer 13 and the second transformer 23 makes it possible for the charging voltage of each of the first capacitor 11 and the second capacitor 21 to reach a target tempering voltage, which is set in advance.

When the first transformer 13 and the second transformer 23 are brought into the reset allowable states and the voltage of each thereof reaches the target tempering voltage, the control circuit 50 turns OFF the first reset switch 45, the second reset switch 46, and the separation switch 38. In addition to the above, the first discharge switch 12 and the second discharge switch 22 are turned ON to discharge the first capacitor 11 and the second capacitor 21 (S6). As a result, the discharge current flows through the first primary winding 13a in the reference sign F1 direction and flows through the second primary winding 23a in the reference sign F2 direction. Due to the above, the current flows through the joining object P, which is held between the upper electrode 61 and the lower electrode 62, via the first secondary winding 13b and the second secondary winding 23b. As a result, the joined portion between the fitting object Pt and the annular object Ps is tempered (a tempering step). When the second discharge (S6) is completed, joining of the joining object P is terminated, and the joined object is manufactured.

In the above description on the operation of the joining device 1, the separation switch 38 is ON in step (S1) of resetting the first transformer 13 and step (S2) of resetting the second transformer 23. However, in step (S1) of resetting the first transformer 13, the separation switch 38 may be turned OFF so as not to supply the current to the second circuit 20 and not to charge the second capacitor 21, and/or in step (S2) of resetting the second transformer 23, the separation switch 38 may be turned OFF so as not to supply the current to the first circuit 10 and not to charge the first capacitor 11. In step (S5), the first reset switch 45 and the second reset switch 46 are simultaneously turned ON to reset the first transformer 13 and the second transformer 23 simultaneously and to charge the first capacitor 11 and the second capacitor 21 simultaneously. However, in the case where the first capacitor 11 and the second capacitor 21 cannot simultaneously be charged, step (S5) is preferably divided into step (S5-1) and step (5-2) (see "Substitute Step for Step 5" in FIG. 4). Step (S5-1) is a step of turning ON the first reset switch 45 to reset the first transformer 13 and to charge the first capacitor 11. Step (S5-2) is a step of turning ON the second reset switch 46 to reset the second transformer 23 and to charge the second capacitor 21. In this case, step (S5-1) only needs to be executed in the same manner as step (S1), and step (S5-2) only needs to be executed in the same manner as step (S2).

As it has been described so far, according to the joining device 1 in this embodiment, the current is supplied to the joining object P, which is sandwiched by the electrode 60, due to the current discharged from the plural capacitors. Thus, it is possible to join the joining object P by causing the relatively large amount of the current to flow through the joining object P. Since the plural capacitors (the first capacitor 11 in the first circuit 10 and the second capacitor 21 in the second circuit 20) can be charged by the single power supply S, it is possible to simplify and downsize the device configuration. Since the separation switch 38 is provided, it is possible to prevent the larger amount of the current than expected from flowing through the first circuit 10 or the second circuit 20. In addition to the above, in the plan view, the first transformer 13 and the second transformer 23 are arranged symmetrically about the electrode 60. Thus, substantially the same amount of the discharge current can flow through the electrode 60 from each of the first circuit 10 and the second circuit 20, and the electromagnetic forces, which are generated from each of the first transformer 13 and the second transformer 23, can equally be applied to the joining object P, which is sandwiched by the electrode 60. In this way, it is possible to suppress the unintended movement of the joining object P. Due to the provision of the reset wire 40, the first reset switch 45, and the second reset switch 46, it is possible to appropriately eliminate the biased magnetization that occurs to the first transformer 13 and the second transformer 23.

In the description that has been made so far, in the first circuit 10, the first capacitor 11 and the first primary winding 13a of the first transformer 13 are connected in parallel with the power supply S. However, the first capacitor 11 and the first primary winding 13a of the first transformer 13 may be connected in series with the power supply S. The same applies to the second circuit 20.

In the description that has been made so far, one each of the capacitors 11, 21 is provided in the first circuit 10 and the second circuit 20, respectively. However, a capacitor bank in which the plural capacitors are connected in parallel may be provided.

In the description that has been made so far, the electric power is supplied to both of the first circuit 10 and the second circuit 20 from the single power supply S. However, the power supply S for supplying the electric power to the first circuit 10 and the power supply S for supplying the electric power to the second circuit 20 may separately be provided.

In the description that has been made so far, two transformers of the first transformer 13 and the second transformer 23 are provided. However, three or more transformers may be provided. Also, in the case where the three or more transformers may be provided, in the plan view, the transformers are preferably arranged symmetrically (typically, to be point-symmetric) about the electrode 60. In the case where the plural transformers are provided, the even number of the transformers is preferably provided from a perspective of ease of symmetrical arrangement.

In the description that has been made so far, the separation switch 38 is provided at the second charging wire 32. However, the separation switch 38 may be provided at the first charging wire 31 instead of the second charging wire 32, or may be provided at both of the second charging wire 32 and the first charging wire 31.

In the description that has been made so far, the joining object P is subjected to Ring Mash joining. However, the joining object P may be subjected to Ring Projection joining, or may be joined by another method.

The circuit diagram that has been described so far and illustrated in FIG. 1 can be modified as follows. A first different point is that while, on the power supply S side of the first reset switch 45, the second reset wire 42 is branched from the reset wire 40 in FIG. 1, in a modified example, the second reset wire 42 is connected to wire that connects the first discharge switch 12 and the first primary winding 13a in the first circuit 10 so as to supply the reset current from the first circuit 10 to the second circuit 20. That is, in the modified example, the reset wire 40 is not branched, and the reset current that is supplied to the second circuit 20 flows via the first circuit 10. A second different point is that, while the first reset switch 45 is provided at the first reset wire 41 in FIG. 1, in the modified example, the first reset switch 45 is moved onto the wire that connects the power supply S and the wire connecting the first capacitor 11 and the first discharge switch 12, and while the second reset switch 46 is provided at the second reset wire 42 in FIG. 1, in the modified example, the second reset switch 46 is moved onto the wire connecting the power supply S and the wire connecting the second capacitor 21 and the second discharge switch 22. When the thus-configured modified example is operated, the separation switch 38 and the second reset switch 46 may remain OFF or ON in step (S1, S5, S5-1) of resetting the first transformer 13, the separation switch 38 and the first reset switch 45 may remain OFF or ON in step (S2, S5, S5-2) of resetting the second transformer 23, and the first reset switch 45 and the second reset switch 46 are not turned OFF but turned ON in step (S3) of performing main charging of the first capacitor 11 and the second capacitor 21. The first reset switch 45 and the second reset switch 46 may be eliminated from the above modified example, so that if the first reset switch 45 and the second reset switch 46 were present, they would be substantially the same as if they were both always ON.

In the description that has been made so far, the joining device according to the embodiments of the present disclosure have been described mainly with reference to FIGs. 1 to 4 as the example. However, the configurations, structures, numbers, arrangements, shapes, materials, and the like of each of the sections are not limited to the above specific example. The components that are appropriately and selectively adopted by the person skilled in the art are included in the scope of the present invention as long as the gist of the present invention is included.

All references, including publications, patent applications, and patents, cited herein are hereby incorporated by reference to the same extent as if each reference were individually and specifically indicated to be incorporated by reference and were set forth in its entirety herein.

The use of the terms "a" and "an" and "the" and similar referents in the context of describing the invention (especially in the context of the following claims) is to be construed to cover both the singular and the plural, unless otherwise indicated herein or clearly contradicted by context. The terms "comprising," "having," "including," and "containing" are to be construed as open-ended terms (i.e., meaning "including, but not limited to,") unless otherwise noted. Recitation of ranges of values herein are merely intended to serve as a shorthand method of referring individually to each separate value falling within the range, unless otherwise indicated herein, and each separate value is incorporated into the specification as if it were individually recited herein. All methods described herein can be performed in any suitable order unless otherwise indicated herein or otherwise clearly contradicted by context. The use of any and all examples, or exemplary language (e.g., "such as") provided herein, is intended merely to better illuminate the invention and does not pose a limitation on the scope of the invention unless otherwise claimed. No language in the specification should be construed as indicating any non-claimed element as essential to the practice of the invention.

Preferred embodiments of this invention are described herein, including the best mode known to the inventors for carrying out the invention. Variations of those preferred embodiments may become apparent to those of ordinary skill in the art upon reading the foregoing description. The inventors expect skilled artisans to employ such variations as appropriate, and the inventors intend for the invention to be practiced otherwise than as specifically described herein. Accordingly, this invention includes all modifications and equivalents of the subject matter recited in the claims appended hereto as permitted by applicable law. Moreover, any combination of the above-described elements in all possible variations thereof is encompassed by the invention unless otherwise indicated herein or otherwise clearly contradicted by context.

## Claims

1. A joining device, comprising:
a first circuit in which a primary-side winding of a first transformer and a first capacitor are connected;
a second circuit in which a primary-side winding of a second transformer and a second capacitor are connected;
an electrode connected to a secondary-side winding of the first transformer and a secondary-side winding of the second transformer, the electrode being configured to sandwich an object to be joined; and
a charge switch configured to switch between presence and absence of supply of electric power from a power supply to the first capacitor and the second capacitor without the primary-side winding of the first transformer and the primary-side winding of the second transformer being interposed, the power supply supplying electric power to the first circuit and the second circuit,
wherein the first circuit has a first discharge switch configured to switch between an energized state and a de-energized state, the energized state being a state in which a current caused by energy stored in the first capacitor flows through the first capacitor and the primary-side winding of the first transformer in the first circuit, the de-energized state being a state in which the current caused by the energy stored in the first capacitor does not flow through the first capacitor and the primary-side winding of the first transformer, and
wherein the second circuit has a second discharge switch configured to switch between an energized state and a de-energized state, the energized state being a state in which a current caused by energy stored in the second capacitor flows through the second capacitor and the primary-side winding of the second transformer in the second circuit, the de-energized state being a state in which the current caused by the energy stored in the second capacitor does not flow through the second capacitor and the primary-side winding of the second transformer.

2. The joining device according to claim 1, wherein a plurality of transformers including the first transformer and the second transformer is arranged symmetrically about the electrode in plan view.

3. The joining device according to claim 1 or claim 2, further comprising:
a charging wire configured to cause the current to flow from the single power supply toward the first capacitor and the second capacitor without the primary-side winding of the first transformer and the primary-side winding of the second transformer being interposed, the charging wire being provided with the charge switch, the charging wire comprising a connection charging wire with which a connecting portion between the primary-side winding of the first transformer and the first capacitor and a connecting portion between the primary-side winding of the second transformer and the second capacitor are connected.

4. The joining device according to claim 3, further comprising:
a separation switch provided at the connection charging wire, wherein the separation switch switches between energization and de-energization.

5. The joining device according to claim 4, further comprising:
a first control circuit configured to control the charge switch, the separation switch, the first discharge switch, and the second discharge switch in a manner to bring the charge switch and the separation switch into an energized state and bring the first discharge switch and the second discharge switch into a de-energized state to charge the first capacitor and the second capacitor, and thereafter bring the charge switch and the separation switch into a de-energized state and bring the first discharge switch and the second discharge switch into an energized state to cause the current to flow through the first circuit and the second circuit, to thereby cause the current to flow through the electrode, which sandwiches the object to be joined, and join the object to be joined.

6. The joining device according to any one of claim 1 to claim 5, further comprising:
a first reset wire through which the current flows from the power supply toward the first circuit, through the first reset wire, the current from the power supply bypassing the charge switch and flowing to a connecting portion between the primary-side winding of the first transformer and the first discharge switch;
a second reset wire through which the current flows from the power supply toward the second circuit, through the second reset wire, the current from the power supply bypassing the charge switch and flowing to a connecting portion between the primary-side winding of the second transformer and the second discharge switch; and
a second control circuit configured to execute a reset mode for controlling the charge switch, the first discharge switch, and the second discharge switch, before the current flows through the first circuit and the second circuit via the charge switch, in a manner to bring the charge switch, the first discharge switch, and the second discharge switch into the de-energized state to charge at least one of the first capacitor or the second capacitor with the current flowing through at least one of the first reset wire or the second reset wire.

7. The joining device according to claim 6, wherein:
the first reset wire has a first reset switch for switching between energization and de-energization between the power supply and the first circuit,
the second reset wire has a second reset switch for switching between energization and de-energization between the power supply and the second circuit, and
in a case of executing the reset mode, the second control circuit controls the first reset switch and the second reset switch in a manner to bring the first reset switch and the second reset switch into the energized state simultaneously or with a time difference to charge the first capacitor and the second capacitor simultaneously or with a time difference.

8. A method for manufacturing a joined object in which the object to be joined is joined by using the joining device according to any one of claim 1 to claim 7, the method comprising:
an object supply step of supplying the object to be joined in a manner to be sandwiched by the electrode; and
a joining step of causing a current to flow through the electrode, which sandwiches the object to be joined, to join the object to be joined.
